(19) Europäisches Patentamt
European Patent Office
Office européen des brevets

(11) **EP 0 924 761 B1**

(12) **EUROPEAN PATENT SPECIFICATION**

(45) Date of publication and mention
of the grant of the patent:
**14.02.2007 Bulletin 2007/07**

(51) Int Cl.:
***H01L 23/373*** (2006.01)

(21) Application number: **98124343.9**

(22) Date of filing: **21.12.1998**

(54) **Heat-conductive and pressure-sensitive adhesive sheets and method for fixing electronic parts to heat-radiating members with the use of the same**

Wärmeleitende und druckempfindliche Klebefolie und Verfahren zur Befestigung elektronischer Bauteile auf wärmeabstrahlende Teile mittels derselben

Feuille adhésive conductrice de chaleur et sensible à la pression et procédé pour fixer des composants électroniques sur des membres radiateurs de chaleur à l'aide de celle-ci

(84) Designated Contracting States:
**BE DE FR GB**

(30) Priority: **22.12.1997 JP 35310197**

(43) Date of publication of application:
**23.06.1999 Bulletin 1999/25**

(73) Proprietor: **NITTO DENKO CORPORATION Osaka (JP)**

(72) Inventors:
• **Kitakura, Kazuyuki**
**Ibaraki-shi,**
**Osaka (JP)**
• **Oura, Masahiro**
**Ibaraki-shi,**
**Osaka (JP)**
• **Muta, Shigeki**
**Ibaraki-shi,**
**Osaka (JP)**
• **Yoshikawa, Takao**
**Ibaraki-shi,**
**Osaka (JP)**

(74) Representative: **Grünecker, Kinkeldey, Stockmair & Schwanhäusser Anwaltssozietät Maximilianstrasse 58 80538 München (DE)**

(56) References cited:
**EP-A- 0 528 606       EP-A- 0 566 093**
**EP-A- 0 872 532       DE-A- 3 219 442**

• **PATENT ABSTRACTS OF JAPAN vol. 013, no. 090 (M-803), 2 March 1989 & JP 63 283918 A (TOYODA GOSEI CO LTD), 21 November 1988**
• **PATENT ABSTRACTS OF JAPAN vol. 012, no. 467 (C-550), 7 December 1988 & JP 63 189458 A (DAINIPPON INK & CHEM INC), 5 August 1988**
• **PATENT ABSTRACTS OF JAPAN vol. 012, no. 373 (C-534), 6 October 1988 & JP 63 125532 A (HITACHI CHEM CO LTD), 28 May 1988**
• **PATENT ABSTRACTS OF JAPAN vol. 012, no. 073 (M-674), 8 March 1988 & JP 62 216732 A (HITACHI CHEM CO LTD), 24 September 1987**

**Description**

FIELD OF THE INVENTION

This invention relates to heat-conductive and pressure-sensitive adhesive sheets in the form of sheets, tapes, etc. which are usable in, for example, fixing electronic parts, in particular, fixing an electronic part to a heat-radiating member, and for fixing members in various fields such as building materials, vehicles, aircrafts and ships.

BACKGROUND OF THE INVENTION

With an increase of integration of IC circuits, heat value is increased in electronic parts such as hybrid packages, multimodules, and sealed-type integrated circuits with plastics and metals. Since the increase of temperature due to the increased heat value may cause malfunction of the electronic parts, a countermeasure for preventing the malfunction by attaching a heat-radiating member such as a heat sink to the electronic part has been taken.

As a method for providing electronic parts with heat-radiating members, a method which comprises using an adhesive prepared by adding aluminum powder etc. to a composition comprising a polymerizable acrylate monomer and a free radical initiator is proposed in U.S. Patent 4,772,960. In this method, after the adhesive is applied onto one or both of the electronic part and the heat-radiating member, it is necessary to effect curing treatment using a primer or blocking oxygen. Such an adhesion treatment needs a long time and much labor, and the materials to be adhered have to be fixed temporally until the completion of curing, thereby resulting in poor efficiency in producing the electronic devices.

Further, U.S. Patent 4,606,962 proposes to use an adhesive tape which has an adhesive layer containing silver grains having a diameter exceeding the thickness of the layer. When silver grains are added in the process of the preparation of the adhesive composition, the viscosity of the composition is extremely increased and, as a result, the composition becomes poor in flowability and handling properties, in particular, coating workability. When such a composition is formed into a tape, no thickness accuracy can be achieved, and in the worst case, no tape can be obtained.

Also, JP-A-6-88061 corresponding to EP 566093 A1 (the term "JP-A" as used herein means an "unexamined published Japanese patent application") discloses a method with the use of heat-conductive and electrical insulating tapes comprising alkyl acrylate polymers containing polar monomers in which heat-conductive and electrical insulating grains are dispersed at random. With the recent increase of integration of member packaging, high electrical insulating properties are needed in such tapes for electronic parts. However, the above-mentioned heat-conductive and electrical insulating tapes have no base material, which makes it impossible to regulate pinholes in the sheets. Moreover, it is feared that the terminal of an electronic part might penetrate into the pressure-sensitive adhesive and thus seriously deteriorate the electrical insulating properties (volume resistivity, breakdown voltage). Therefore, the above-mentioned heat-conductive and electrical insulating tapes are unusable in sites where a high reliability is needed.

On the other hand, as a heat-conductive interfacial material located between a heat source and a radiator, JP-A-5-198709 (U.S. Patent 5,213,868) proposes a heat-conductive material comprising, as a base material, a plastic film (made of nylon, polyesters, polyimides(amides), etc.) optionally containing aluminum oxide or boron nitride and a layer of a pressure-sensitive acrylic adhesive containing a heat-conductive filler formed thereon and perforated, embossed or grooved so as to remove the air between the heat source and the radiator. However, these materials are poor in the adhesion between the base material and the pressure-sensitive adhesive layer and suffer from a problem of peeling between these members when used at high temperatures, i.e., anchoring fracture.

It is frequently attempted in the art to form one or more undercoating layers between a base material and a pressure-sensitive adhesive layer so as to improve the adhesion between them. This treatment comprises using an undercoating material having a polarity between those of the base material and the pressure-sensitive layer, dissolving the material in, for example, an organic solvent, and then applying it onto the base material followed by drying. However, the application of this method to the above-mentioned heat-conductive materials, etc. suffers from some troubles such as a need for complicated operations and worsened working environment due to the use of the organic solvent.

Considering the above-mentioned problems encountering in the prior arts, the present invention aims at providing heat-conductive and pressure-sensitive adhesive sheets which are to be used in fixing electronic parts to heat-radiating members and for fixing members in various fields such as building materials, vehicles, aircrafts and ships and can achieve the above-mentioned objects of fixing while needing neither a long time nor much labor in adhesion. The heat-conductive and pressure-sensitive adhesive sheets of the present invention, which are composed of a base material and a pressure-sensitive adhesive layer formed thereon, are excellent in electrical insulating properties and heat conductivity, result in no troubles such as complicated operations or worsened working environment during the production thereof, show excellent adhesion between the base material and the pressure-sensitive adhesive layer, scarcely undergo anchoring fracture between them and have excellent heat resistance.

In order to achieve the above-mentioned object, the present inventors have conducted extensive studies and, as a result, have achieved the present invention based on the finding that heat-conductive and pressure-sensitive adhesive sheets having excellent heat resistance and improved adhesion of the adhesive layer to the base material and scarcely undergoing anchoring fracture between the base material and the adhesive layer can be obtained by using a plastic film containing a heat-conductive granular solid as a base material, and forming a layer of a pressure-sensitive adhesive composition containing a specific adhesive thereon.

## SUMMARY OF THE INVENTION

Accordingly, the present invention relates to a heat-conductive and pressure-sensitive adhesive sheet comprising a plastic film containing from 2 to 50% by volume of a heat-conductive granular solid as a base material and a pressure-sensitive adhesive composition layer formed on one or both of the surfaces of said plastic film, said pressure-sensitive adhesive composition layer containing a base polymer and from 0.01 to 20 parts by weight of a silane coupling agent based on 100 parts by weight of the base polymer. The present invention further relates to a method for fixing electronic parts to heat-radiating members characterized in that the electronic parts are adhered and fixed to the heat-radiating members via the heat-conductive and pressure-sensitive adhesive sheets as described above.

## DETAILED DESCRIPTION OF THE INVENTION

Examples of the base material which can be used in the present invention include a plastic film made of polyimides(amides), polyester, fluoroplastics, polypropylene or polyethylene, generally having a thickness of from 12$\mu$m to 4mm and containing a heat-conductive granular solid in the film. From the viewpoint of heat dimension stability and reliability in long-term heat resistance, polyimide(amide) films or fluoroplsatic films are preferred, and polyimide (amide) films, i.e., polyimide films or polyamide films are more preferred.

Examples of the above-mentioned heat-conductive granular solid include $SiO_2$, $TiB_2$, BN, $Si_3N_4$, TiOz, MgO, NiO, CuO, $Al_2O_3$, $Fe_2O_3$, etc. From the viewpoints of heat conductivity and availability, it is preferred to use BN (boron nitride) or $Al_2O_3$ (aluminum oxide). Such a heat-conductive granular solid generally has a particle diameter of from 0.5 to 250$\mu$m, preferably from 1 to 100$\mu$m and still preferably from 2 to 10$\mu$m. These particles may be in any form such as spheres, needles, flakes or stars.

The content of the heat-conductive granular solid ranges from 2 to 50% by volume, preferably from 10 to 35% by volume. When the content of the heat-conductive granular solid is less than 2% by volume, the aimed high heat conductivity of the heat-conductive and pressure-sensitive adhesive sheets cannot be achieved. In such a case, moreover, any good adhesion can be hardly obtained between the film and the pressure-sensitive adhesive composition layer formed thereon. When the content thereof exceeds 50% by volume, some problems in film strength, etc. are liable to be caused.

In the present invention, the base materials having the above-mentioned constitution can be prepared in accordance with a well known method for forming films. Alternatively, use may be made of commercially available products. For example, "KAPTON MT" manufactured by Du Pont-Toray Co., Ltd., which is a polyimide film containing $Al_2O_3$ at the ratio within the range as specified above, is usable therefor as such.

The pressure-sensitive adhesive composition of the present invention comprises a base polymer and a silane coupling agent in an amount of from 0.01 to 20 parts by weight, preferably from 0.05 to 10 parts by weight, and more preferably from 0.1 to 1 part by weight based on 100 parts by weight of the base polymer. This constitution contributes to the improvement in the adhesion of the base material to the pressure-sensitive adhesive layer, thus making it possible to give heat-conductive and pressure-sensitive adhesive sheets having excellent heat resistance without resort to undercoating of the base material, which scarcely undergo anchoring fracture between the base material and the pressure-sensitive adhesive layer and cause no problem such as complicated operations or worsened working environment due to the use of organic solvents.

When the content of the silane coupling agent is less than 0.01 part by weight per 100 parts by weight of the base polymer, only insufficient adhesion is achieved between the base material and the pressure-sensitive adhesive composition layer. As a result, there arises a problem in the adhesion/fixation power of electronic parts to heat radiating members due to anchoring fracture between the base material and the pressure-sensitive adhesive composition layer. When the content thereof exceeds 20 parts by weight, the cohesive force of the pressure-sensitive adhesive composition is excessively elevated and thus the adhesion properties are adversely affected (decrease in adhesion, etc.).

JP-B-62-30233 (the term "JP-B" as used herein means an "examined Japanese patent publication") also discloses the addition of a silane coupling agent such as vinylsilane or epoxysilane to a pressure-sensitive adhesive composition. In this patent, however, a silane coupling agent is added in order to improve the adhesion of the composition to glass employed as an adherent, as stated in Examples thereof. Namely, this patent does not aim at improving the adhesion to plastic films serving as the base material in adhesive sheets, as the present invention does. This patent neither discloses nor suggests the above-mentioned constitution and effects of the present invention on the basis of the combined use of a specific base material with a pressure-sensitive adhesive composition.

**EP 0 924 761 B1**

The silane coupling agent to be used in the present invention is an organosilicon monomer having two or more different reactive groups in its molecule. One of these two reactive groups is a reactive group capable of chemically binding to an inorganic matter while another is a reactive group capable of chemically binding to organic materials. Examples of the reactive group capable of chemically binding to inorganic matters include methoxy, ethoxy and silanol groups, while examples of the reactive group capable of chemically binding to organic materials include vinyl, epoxy, methacryl, amino and mercapto groups.

Examples of the silane coupling agent include vinyltrichlorosilane, vinyltris(β-methoxyethoxy)silane, vinyltriethoxysilane, vinyltrimethoxysilane, γ-methacryloxypropyltrimethoxysilane, β-(3,4-epoxycyclohexyl)ethyltrimethoxysilane, γ-glycidoxypropyltrimethoxysilane, γ-glycidoxypropylmethyldiethoxysilane, N-β-(aminoethyl)-γ-aminopropyltrimethoxysilane, N-β-(aminoethyl)-γ-aminopropylmethyldimethoxysilane, γ-aminopropyltriethoxysilane, N-phenyl-γ-aminopropyltrimethoxysilane,γ-mercaptopropyltrimethoxysilane, γ-chloropropyltrimethoxysilane, γ-glycidoxypropyltriethoxysilane, γ-methacryloxypropylmethyldiethoxysilane, γ-methacryloxypropyltriethoxysilane, N-β-(aminoethyl)-γ-aminopropyltriethoxysilane and γ-aminopropyltrimethoxysilane. One or more of these compounds can be selected and employed by considering compatibility with the pressure-sensitive adhesive composition, thickening effect, gelation, etc.

As the pressure-sensitive adhesive composition to which the silane coupling agent is to be added, it is possible to use various well known compositions containing rubber or synthetic resins as the base polymer. When the purposes of the use of the heat-conductive and pressure-sensitive adhesive sheets of the present invention are taken into consideration, it is particularly preferred to use a pressure-sensitive adhesive composition containing an alkyl (meth) acrylate polymer which is capable of maintaining a high reliability over a long time as the base polymer.

The alkyl (meth)acrylate polymers can be synthesized by block polymerization, solution polymerization, emulsion polymerization, suspension polymerization, etc. Among these polymerization methods, it is preferable to employ the block polymerization method in which the polymerization is effected with irradiation of radiation such as UV light or electron beams. This polymerization method is free from troubles such as corrosion of electronic parts due to residual organic solvents, swelling, peeling or deviation caused by vaporization and swelling of the solvent at high temperatures, and contamination, insufficient adhesion or decrease in moisture resistance caused by bleeding of emulsifiers. The molecular weight of the resultant polymer can be increased by irradiating relatively weak UV light, thereby providing a pressure-sensitive adhesive composition having a particularly excellent heat resistance, i.e., a high degree of crosslinkage and high cohesive force.

To produce the alkyl (meth)acrylate polymers, use may be made, as the main monomer, of alkyl (meth)acrylates having 2 to 14 carbon atoms in the alkyl group such as butyl (meth)acrylate, 2-ethylhexyl (meth)acrylate, isooctyl (meth) acrylate and isononyl (meth)acrylate. To improve the adhesion and to control the glass transition temperature of the polymer so as to improve the cohesive force and heat resistance thereof, it is also possible to use a monomer for modification copolymerizable with the above-mentioned main monomer. Examples of the copolymerizable monomer for modification include acrylic acid, itaconic acid, sulfopropyl acrylate, hydroxyalkyl acrylate, cyanoalkyl acrylate, acrylamide, substituted acrylamide, N-vinylcaprolactam, acrylonitrile, 2-methoxyethyl acrylate, glycidyl acrylate, caprolactone-modified acrylate, caprolactam-modified hydroxyethyl acrylate, vinyl acetate and styrene. Either one or two or more of these monomers can be employed.

The alkyl (meth)acrylate serving as the main monomer can be used in an amount of from 70 to 100% by weight, preferably from 80 to 95% by weight, while the copolymerizable monomer for modification can be used in an amount of from 0 to 30% by weight, preferably from 5 to 20% by weight. By using these monomers at the ratio as specified above, well-balanced adhesion, cohesive force, etc. can be achieved. It is also possible to use oligomers of the above monomers, commercially available oligomers such as polyols and ethers, thickeners, etc. so long as the adhesion properties of the pressure-sensitive adhesive composition are not adversely affected. The alkyl (meth)acrylate polymer generally has a weight-average molecular weight of 100,000 to 6,000,000.

To elevate the shear strength, the pressure-sensitive adhesive composition may further contain an external crosslinking agent, for example, polyfunctional isocyanate crosslinking agents such as tolylene diisocyanate, trimethylolpropane tolylene diisocyanate and diphenylmethane triisocyanate; epoxy crosslinking agents such as polyethylene glycol diglycidyl ether, diglycidyl ether and trimethylolpropane triglycidyl ether; melamine resin crosslinking agents; metallic salt crosslinking agents; metallic chelate crosslinking agents; amino resin crosslinking agents; and peroxide crosslinking agents. The crosslinking agent can be added generally in an amount of from 0.01 to 10 parts by weight per 100 parts by weight of the base polymer.

In the synthesis of the base polymer such as an alkyl (meth)acrylate polymer, an internal crosslinking agent may be further added. Examples of the internal crosslinking agents include polyfunctional (meth)acrylates such as trimethylolpropane tri(meth)acrylate, pentaerythritol tetra(meth)acrylate, 1,2-ethyleneglycol di(meth)acrylate and 1,6-hexanediol di(meth)acrylate. It is preferred to use these internal crosslinking agents generally in an amount of from 0.02 to 5 parts by weight, preferably from 0.1 to 3 parts by weight per 100 parts by weight of the monomer mixture for synthesizing the polymer. A bifunctional compound may be used in a somewhat large amount while a trifunctional or higher compound may be used in a smaller amount each falling within the range as specified above.

The pressure-sensitive adhesive composition can further contain a heat-conductive filler in order to elevate the heat conductivity of the heat-conductive and pressure-sensitive adhesive sheets. As the heat-conductive filler, use can be made of the same compounds as the above-mentioned ones employed as the heat-conductive granular solid to be incorporated into the plastic film for the base material. The particle size and form of the heat-conductive filler are the same as those described above. From the viewpoint of avoiding an increase in the viscosity of the pressure-sensitive adhesive composition, it is preferable that such a filler has a purity of at least 95% by weight. It is recommended that the heat-conductive filler is used generally in an amount of from 10 to 300 parts by weight, preferably from 10 to 120 parts by weight, per 100 parts by weight of the base polymer.

In the pressure-sensitive adhesive composition of the present invention, the above-mentioned external crosslinking agent, internal crosslinking agent and heat-conductive filler can be added to the base polymer if necessary. Moreover, the pressure-sensitive adhesive of the present invention may further contain various additives commonly employed in pressure-sensitive adhesives such as pigments, fillers, age resistors, tackifiers, flame-retardants, etc. generally in an amount of 0.01 to 100 parts by weight per 100 parts by weight of the base polymer.

Now a process for obtaining a pressure-sensitive adhesive composition containing an alkyl (meth)acrylate polymer as the base polymer, which is a typical example of the pressure-sensitive adhesive composition of the present invention, by block photopolymerization will be described. First, a photopolymerization initiator is added to an alkyl (meth) acrylate (optionally mixed with a monomer for modification copolymerizable therewith). Next, the obtained premix is partly polymerized to give a coatable syrup having a viscosity of 500 to 5,000 cP. After adding a silane coupling agent to the syrup, a polyfunctional (meth)acrylate serving as an internal crosslinking agent, a heat-conductive filler and an additional photopolymerization initiator are added thereto, if needed. Thus, a composition for photopolymerization can be obtained. Then, this composition is applied onto a release liner and polymerized by irradiating with UV light or radiation, thus giving the pressure-sensitive adhesive composition of the present invention.

The heat-conductive and pressure-sensitive adhesive sheet of the present invention are produced by transferring the above-mentioned pressure-sensitive adhesive composition onto the above-mentioned plastic film containing a heat-conductive granular solid which serves as the base material. Alternatively, the above-mentioned composition for photopolymerization may be applied directly onto the base material and then polymerized to give a pressure-sensitive adhesive composition and to form a heat-conductive and pressure-sensitive adhesive sheet simultaneously. In these cases, the pressure-sensitive adhesive composition layer may be formed either one or both of the surfaces of the base material. It is preferred that the pressure-sensitive adhesive composition layer has generally a thickness of from 10 to 300μm on one surface.

The heat-conductive and pressure-sensitive adhesive sheets in the form of sheets or tapes thus produced are excellent in electrical insulating properties and heat-conductivity, have pressure-sensitive adhesion to an adherent, exhibit good adhesion between the base material and the pressure-sensitive adhesive composition layer without resort to any undercoating procedure, which causes problems of complicated operations or worsened working environment, scarcely undergo anchoring fracture between the base material and the pressure-sensitive adhesive composition layer, and exhibit high heat resistance.

To adhere and fix an electronic part to a heat-radiating member by using the heat-conductive and pressure-sensitive adhesive sheet according to the present invention, the heat-conductive and pressure-sensitive adhesive sheet is inserted between the electronic part and the heat-radiating member, followed by contact bonding, thereby making use of the pressure-sensitive adhesion. Thus, the electronic part and the heat-radiating member can be well fixed while achieving a high heat-conductivity and a high adhesion strength even at high temperatures.

The electronic parts to be adhered and fixed are not particularly restricted. Examples thereof include IC tips, hybrid packages, multi-tip modules, power transistors and sealed-type integrated circuits made of plastics or metals. The present invention can be advantageously applied to the adhesion and fixation of electronic parts with a large heat value, for example, those employed in highly integrated circuits. The heat-radiating members, i.e., another subject to be adhered and fixed, include heat sinks made of metal plates and sheets and radiators. The thickness of the heat sinks generally ranges from 10μm to 10mm, preferably from 100μm to 3mm, though the present invention is not restricted thereto. The radiators may have arbitrary structures, for example, those provided with cooling fins.

The heat conductive and pressure-sensitive adhesive sheets of the present invention may be used not only in adhering and fixing these electronic parts to the heat-radiating members but also in fixing members in various fields including building materials, vehicles, aircrafts and ships. It is needless to say that the heat-conductive and pressure-sensitive adhesive sheets can achieve the above-mentioned effects when employed for these purposes.

EXAMPLES

To further illustrate the present invention in greater detail, the following Examples will be given wherein all parts are by weight.

Example 1

A premix comprising 75 parts of isooctyl acrylate, 20 parts of butyl acrylate, 5 parts of acrylic acid and 0.1 part of 2,2-dimethoxy-2-phenylacetone (a photopolymerization initiator) was exposed to UV light in a nitrogen atmosphere and thus partly polymerized to give a coatable syrup having a viscosity of about 40 P (poise). To 100 parts of this syrup were added 0.2 parts of trimethylolpropane triacrylate (an internal crosslinking agent) and 40 parts of boron nitride (BN). Then, 0.3 part of γ-glycidoxypropyltrimethoxysilane was further added to obtain a composition for photopolymerization.

This composition for photopolymerization was applied onto a release liner and then photopolymerized by irradiating with UV light at 900 mj/cm$^2$ with the use of a high-pressure mercury lamp having a light intensity of 5 mW/cm$^2$ in a nitrogen gas atmosphere. Next, it was dried at 130°C for 5 minutes by means of a hot-air circulatory dryer, thus forming a pressure-sensitive adhesive composition layer of 50μm in thickness. This pressure-sensitive adhesive composition layer was transferred onto the both surfaces of a polyimide film (a base material) containing about 17% by volume of Al$_2$O$_3$ and having a thickness of 25μm to thereby give a heat-conductive and pressure-sensitive adhesive sheet of 125μm in total thickness.

Example 2

A premix comprising 70 parts of isononyl acrylate, 20 parts of butyl acrylate, 10 parts of acryloylmorpholine and 0.1 part of 2,2-dimethoxy-2-phenylacetone (a photopolymerization initiator) was exposed to UV light in a nitrogen atmosphere and thus partly polymerized to give a coatable syrup having a viscosity of about 40 P. To 100 parts of this syrup were added 0.2 parts of trimethylolpropane triacrylate (an internal crosslinking agent) and 100 parts of alumina (Al$_2$O$_3$). Then, 0.1 part of N-β-(aminoethyl)γ-aminopropyltrimethoxysilane was added to obtain a composition for photopolymerization.

This composition for photopolymerization was applied onto a release liner and then photopolymerized by irradiating with UV light at 900 mj/cm$^2$ with the use of a high-pressure mercury lamp having a light intensity of 5 mW/cm$^2$ in a nitrogen gas atmosphere. Next, it was dried at 130°C for 5 minutes by means of a hot-air circulatory dryer, thus forming a pressure-sensitive adhesive composition layer having a thickness of 50μm. This pressure-sensitive adhesive composition layer was transferred onto the both surfaces of a polyimide film containing about 17% by volume of Al$_2$O$_3$ and having a thickness of 25μm to thereby give a heat-conductive and pressure-sensitive adhesive sheet of 125μm in total thickness.

Example 3

In 210 parts of ethyl acetate, 95 parts of 2-ethylhexyl acrylate and 5 parts of acrylic acid were subjected to solution polymerization in the coexistence of 0.4 parts of 2,2-azobisisobutyronitrile while stirring under nitrogen replacement at 60 to 80°C to thereby obtain a polymer solution having a viscosity of about 120 P, a degree of polymerization of 99.2% by weight and a solid content of 30.0% by weight. To this solution were added, per 100 parts of the base polymer, 3 parts of a polyfunctional isocyanate crosslinking agent and 40 parts of boron nitride (BN). Then, 0.2 parts of γ-glycidoxypropylmethyldiethoxysilane was added to obtain a solution of a pressure-sensitive adhesive composition.

This solution of the composition for photopolymerization was applied onto a release liner and then dried at 40°C for 5 minutes and then at 130°C for 5 minutes by means of a hot-air circulatory dryer, thus forming a pressure-sensitive adhesive composition layer having a thickness of 50μm. This pressure-sensitive adhesive composition layer was transferred onto the both surfaces of a polyimide film containing about 17% by volume of Al$_2$O$_3$ and having a thickness of 25μm to thereby give a heat-conductive and pressure-sensitive adhesive sheet of 125μm in total thickness.

Example 4

A heat-conductive and pressure-sensitive adhesive sheet of 75μm in total thickness was obtained in the same manner as in Example 1 except for adding no boron nitride (BN) to the composition for photopolymerization and regulating the thickness of the pressure-sensitive adhesive composition layer formed by the photopolymerization to 25μm.

Comparative Example 1

A heat-conductive and pressure-sensitive adhesive sheet of 125μm in total thickness was obtained in the same manner as in Example 1 except for using a polyimide film being free from any heat-conductive granular solid such as Al$_2$O$_3$ and having a thickness of 25μm as a base material in place of the polyimide film containing about 17% by volume of Al$_2$O$_3$ and having a thickness of 25μm.

Comparative Example 2

A heat-conductive and pressure-sensitive adhesive sheet of 125$\mu$m in total thickness was obtained in the same manner as in Example 1 except for adding no boron nitride (BN) to the composition for photopolymerization.

Comparative Example 3

A heat-conductive and pressure-sensitive adhesive sheet of 125$\mu$m in total thickness was obtained in the same manner as in Example 1 except for adding no $\gamma$-glycidoxypropyltrimethoxysilane to the composition for photopolymerization.

Comparative Example 4

A heat-conductive and pressure-sensitive adhesive sheet of 125$\mu$m in total thickness was obtained in the same manner as in Example 2 except for adding not 0.1 but 0.005 part of N-$\beta$-(aminoethyl)$\gamma$-aminopropyltrimethoxysilane to the composition for photopolymerization.

The heat-conductive and pressure-sensitive adhesive sheets obtained in the above Examples 1 to 4 and Comparative Examples 1 to 4 were each subjected to the following retentive force resistance to heat shear test and heat resistance test. The obtained results are shown in Table below.

Retentive Force Resistant to Heat Shear Test

A heat-conductive and pressure-sensitive adhesive sheet (width: 10mm) was adhered to one lengthwise end of an aluminum plate (125 x 25 x 0.4mm) to obtain an adhesion area of 20 x 10mm. After allowing to stand at 80°C for 30 minutes, a load (500 g) was applied in the lengthwise direction of the adhesive sheet at 80°C. It was examined whether or not the sheet was kept for 120 minutes or longer without dropping. "A" means a case where the sheet was kept for 120 minutes or longer while "B" means a case where the sheet dropped less than 120 minutes.

Heat Resistance Test

By using a heat-conductive and pressure-sensitive adhesive sheet, a transistor in a TO-220 package (in terms of a standard of Joint Electron Device Engineering Council) was adhered and fixed under a contact bonding pressure of 2 kg/cm$^2$ to a heat sink which had been immersed in water to obtain a constant temperature. Then, a definite output was supplied to the transistor and the difference (T2-T1) in the transistor temperature (T2) from the temperature of the lower surface of the heat-conductive and pressure-sensitive adhesive sheet (T1) was measured. Next, the heat resistance was calculated in accordance with the following formula.

$$\text{Heat resistance } (°C \cdot cm^2/W) = (T2 - T1) \times A/P$$

A: transistor area (cm$^2$).
P: electrical power (W) consumed by transistor.

The transistor temperature (T2) was measured by using a thermocouple spot-welded to the metallic base of the transistor package. On the other hand, the temperature of the lower surface of the heat-conductive and pressure-sensitive adhesive sheet (T1) was measured by forming a small hole in the heat sink and inserting a thermocouple thereinto. The thermocouple was placed in the heat sink such that it did not give influence onto the adhered area of the heat-conductive and pressure-sensitive adhesive sheet, with the proviso that the location of the thermocouple was as near as possible to the interface between the heat sink and the adhesive sheet.

TABLE

| Sample No. | Retentive Force Resistant to Heat Shear Test | Heat Resistance Test (°C•cm$^2$/W) |
| --- | --- | --- |
| Example 1 | A | 4.3 |
| Example 2 | A | 4.2 |
| Example 3 | A | 4.3 |

(continued)

| Sample No. | Retentive Force Resistant to Heat Shear Test | Heat Resistance Test (°C•cm$^2$/W) |
|---|---|---|
| Example 4 | A | 7.0 |
| Comp. Example 1 | B | 6.0 |
| Comp. Example 2 | B | 16.0 |
| Comp. Example 3 | B | 4.3 |
| Comp. Example 4 | B | 4.3 |

It can be seen from the results in the above Table that the heat-conductive and pressure-sensitive adhesive sheets of Examples 1 to 4 according to the present invention were each not only maintained for not less than 120 minutes in the retentive force resistant to heat shear test but also achieved satisfactory results in the heat resistance test. In contrast, the heat-conductive and pressure-sensitive adhesive sheets of Comparative Examples 1 to 4 dropped less than 120 minutes in the retentive force resistant to heat shear test due to anchoring fracture between the base material and the pressure-sensitive adhesive composition layer.

As described above, the present invention can provide heat-conductive and pressure-sensitive adhesive sheets which are excellent in electrical insulating properties, heat-conductivity and pressure-sensitive adhesion, exhibit good adhesion between the base material and the pressure-sensitive adhesive composition layer while scarcely undergoing anchoring fracture between the base material and the pressure-sensitive adhesive composition layer, and exhibit high heat resistance. These heat-conductive and pressure-sensitive adhesive sheets are widely usable in fixing electronic parts, in particular, fixing electronic parts to heat-radiating members and for fixing members in various fields including building materials, vehicles, aircrafts and ships.

## Claims

1.  A heat-conductive and pressure-sensitive adhesive sheet comprising a plastic film containing from 2 to 50% by volume of a heat-conductive granular solid as a base material and a pressure-sensitive adhesive composition layer formed on one or both of the surfaces of said plastic film, said pressure-sensitive adhesive composition layer containing a base polymer and being **characterized in** further containing from 0.01 to 20 parts by weight of a silane coupling agent based on 100 parts by weight of the base polymer.

2.  The heat-conductive and pressure-sensitive adhesive sheet of claim 1, wherein said heat-conductive granular solid is aluminum oxide or boron nitride.

3.  The heat-conductive and pressure-sensitive adhesive sheet of claim 1, wherein said plastic film constituting said base material is a polyimide(amide) film.

4.  The heat-conductive and pressure-sensitive adhesive sheet of claim 1, wherein said pressure-sensitive adhesive composition layer contains an alkyl (meth) acrylate polymer as the base polymer.

5.  The heat-conductive and pressure-sensitive adhesive sheet of claim 1, wherein the pressure-sensitive adhesive composition layer further contains a heat-conductive filler.

6.  A method for fixing electronic parts to heat-radiating members, which comprises adhering and fixing said electronic parts to said heat-radiating members via a heat-conductive and pressure-sensitive adhesive sheet comprising a plastic film containing from 2 to 50% by volume of a heat-conductive granular solid as a base material and having formed on one or both of the surfaces of said film a pressure-sensitive adhesive composition layer containing a base polymer and a silane coupling agent in an amount of from 0.01 to 20 parts by weight based on 100 parts by weight of the base polymer.

## Patentansprüche

1.  Wärmeleitende und druckempfindliche Klebefolie, die einen Kunststofffilm umfasst, der 2 bis 50 Vol.-% eines wärmeleitenden körnigen Feststoffs als Grundmaterial und eine auf einer oder beiden Oberflächen des Kunststofffilms gebildete druckempfindliche Klebstoffzusammensetzungsschicht enthält, wobei die druckempfindliche Klebstoffzusammensetzungsschicht ein Grundpolymer enthält und **dadurch gekennzeichnet ist, dass** sie weiter 0,01 bis 20 Gewichtsteile eines Silan-Kupplungsmittels, bezogen auf 100 Gewichtsteile des Grundpolymers, enthält.

**2.** Wärmeleitende und druckempfindliche Klebefolie nach Anspruch 1, worin der wärmeleitende körnige Feststoff Aluminiumoxid oder Bornitrid ist.

**3.** Wärmeleitende und druckempfindliche Klebefolie nach Anspruch 1, worin der Kunststofffilm, welcher das Grundmaterial bildet, ein Polyimid(amid)-Film ist.

**4.** Wärmeleitende und druckempfindliche Klebefolie nach Anspruch 1, worin die druckempfindliche Klebstoffzusammensetzungsschicht ein Alkyl(meth)acrylatPolymer als Grundpolymer enthält.

**5.** Wärmeleitende und druckempfindliche Klebefolie nach Anspruch 1, worin die druckempfindliche Klebstoffzusammensetzungsschicht weiter einen wärmeleitenden Füllstoff enthält.

**6.** Verfahren zum Befestigen elektronischer Teile an Wärme abstrahlenden Bauteilen, welches das Anhaften und Befestigen der elektronischen Teile an die Wärme abstrahlenden Bauteile über eine wärmeleitende und druckempfindliche Klebefolie umfasst, die einen Kunststofffilm umfasst, der 2 bis 50 Vol.-% eines wärmeleitenden körnigen Feststoffs als Grundmaterial enthält und auf einer oder beiden Oberflächen des Films eine druckempfindliche Klebstoffzusammensetzungsschicht gebildet hat, die ein Grundpolymer und ein Silan-Kupplungsmittel in einer Menge von 0,1 bis 20 Gewichtsteilen, bezogen auf 100 Gewichtsteile des Grundpolymers, enthält.

**Revendications**

**1.** Feuille adhésive conductrice de la chaleur et autocollante comprenant un film en matière plastique contenant de 2 à 50 % en volume d'un solide granulaire conducteur de la chaleur en tant que matériau de base et une couche de composition adhésive autocollante formée sur une ou les deux des surfaces dudit film en matière plastique, ladite couche de composition adhésive autocollante contenant un polymère de base et étant **caractérisée en ce qu'**elle contient en outre de 0,01 à 20 parties en poids d'un agent de couplage au silane pour 100 parties en poids du polymère de base.

**2.** Feuille adhésive conductrice de la chaleur et autocollante selon la revendication 1, dans laquelle ledit solide granulaire conducteur de la chaleur est de l'oxyde d'aluminium ou du nitrure de bore.

**3.** Feuille adhésive conductrice de la chaleur et autocollante selon la revendication 1, dans laquelle ledit film en matière plastique constituant ledit matériau de base est un film en poly(imide (amide)).

**4.** Feuille adhésive conductrice de la chaleur et autocollante selon la revendication 1, dans laquelle ladite couche de composition adhésive autocollante contient un polymère de (méth)acrylate d'alkyle en tant que polymère de base.

**5.** Feuille adhésive conductrice de la chaleur et autocollante selon la revendication 1, dans laquelle la couche de composition adhésive autocollante contient en outre une charge conductrice de la chaleur.

**6.** Procédé de fixation de parties électroniques à des organes rayonnants de la chaleur, qui comprend l'adhésion et la fixation desdites parties électroniques auxdits organes rayonnants de la chaleur via une feuille adhésive conductrice de la chaleur et autocollante comprenant un film en matière plastique contenant de 2 à 50 % en volume d'un solide granulaire conducteur de la chaleur en tant que matériau de base et sur laquelle est formée sur une ou les deux des surfaces dudit film une couche de composition adhésive autocollante comprenant un polymère de base et un agent de couplage au silane en une quantité de 0,01 à 20 parties en poids pour 100 parties en poids du polymère de base.